# EUROPÄISCHE PATENTANMELDUNG

(11) **EP 3 151 430 A1**
(43) Veröffentlichungstag der Anmeldung: **05.04.2017**
(21) Anmeldenummer: 15187960.8
(22) Anmeldetag: 01.10.2015
(51) Int. Cl.: H03K 17/14, H02M 1/00

(54) **VERSORGUNGSSPANNUNGSABHÄNGIGE MAXIMALSTROMSTEUERUNG FÜR SPANNUNGSGESTEUERTE HALBLEITER**

(71) Anmelder: Siemens Aktiengesellschaft, 80333 München (DE)
(72) Erfinder: Stadter, Norbert, 96155 Buttenheim (DE)

(57) **Zusammenfassung**

Eine Steuerschaltung (2) für einen spannungsgesteuerten Halbleiterschalter (1) weist eine Grundschaltung (3) auf, der ein Stromistwert (I) des Halbleiterschalters (1) zugeführt wird. Die Grundschaltung (3) führt ein binäres Steuersignal (S) in Abhängigkeit von der Abweichung des Stromistwerts (I) von einem Stromsollwert (I*) nach. Das Steuersignal (S) gibt sie an den Halbleiterschalter (1) aus und steuert den Halbleiterschalter (1) dadurch entsprechend. Der Grundschaltung (3) wird eine Versorgungsspannung (VDD) zugeführt, die weiterhin auch einer Schutzschaltung (6) zugeführt wird. Die Schutzschaltung (6) ermittelt anhand der Versorgungsspannung (VDD) ein Schutzsignal (δI), das zur Begrenzung des vom Halbleiterschalter (1) geschalteten Stroms (I) auf die Abweichung des Stromistwerts (I) vom Stromsollwert (I*) aufgeschaltet wird. Das Schutzsignal (δI) weist einen Basiswert (δI0) auf, wenn die Versorgungsspannung (VDD) einen Nennwert (VDD0) aufweist. Liegt die Versorgungsspannung (VDD) unterhalb des Nennwerts (VDD0), nimmt das Schutzsignal (δI) einen Zwischenwert zwischen dem Basiswert (δI0) und einem Grenzwert (δI1) an. Liegt die Versorgungsspannung (VDD) oberhalb des Nennwerts (VDD0), so weist das Schutzsignal (δI) mindestens den Basiswert (δI0) auf, wenn der Grenzwert (δI1) kleiner als der Basiswert (δI0) ist. Wenn hingegen der Grenzwert (δI1) größer als der Basiswert (δI0) ist, so weist das Schutzsignal (δI) höchstens den Basiswert (δI0) auf. Der Wert des Schutzsignals (δI) ist eine stetige, monotone Funktion des Wertes der Versorgungsspannung (VDD), so dass das Schutzsignal (δI) je nach Wert der Versorgungsspannung (VDD) jeden Wert zwischen dem Basiswert (δI0) und dem Grenzwert (δI1) annehmen kann.

## Beschreibung

Die vorliegende Erfindung geht aus von einer Steuerschaltung für einen spannungsgesteuerten Halbleiterschalter,
- wobei die Steuerschaltung eine Grundschaltung aufweist,
- wobei der Grundschaltung ein Stromistwert des spannungsgesteuerten Halbleiterschalters zugeführt wird,
- wobei die Grundschaltung ein binäres Steuersignal in Abhängigkeit von der Abweichung des Stromistwerts von einem Stromsollwert nachführt,
- wobei die Grundschaltung das entsprechend nachgeführte Steuersignal an den spannungsgesteuerten Halbleiterschalter ausgibt und den spannungsgesteuerten Halbleiterschalter dadurch entsprechend steuert,
- wobei der Grundschaltung eine Versorgungsspannung zugeführt wird.

Eine derartige Steuerschaltung ist weit verbreitet. Beispielsweise finden sich entsprechende Realisierungen in den von der Firma Texas Instruments Inc. vertriebenen integrierten Schaltkreisen mit den Typenbezeichnungen UCCx8C4y (mit x = 1 oder 2 und y = 1 bis 5).

Spannungsgesteuerte Halbleiterschalter für den schaltenden Betrieb müssen so betrieben werden, dass diese im regulären Betrieb entweder den gesättigten Zustand oder den sperrenden Zustand einnehmen. Der Linearbetrieb darf nur für kurze Zeit im Übergang vom gesättigten in den sperrenden Zustand oder umgekehrt auftreten. Anderenfalls würde der spannungsgesteuerte Halbleiterschalter durch die im spannungsgesteuerten Halbleiterschalter auftretenden thermischen Verluste rasch zerstört werden.

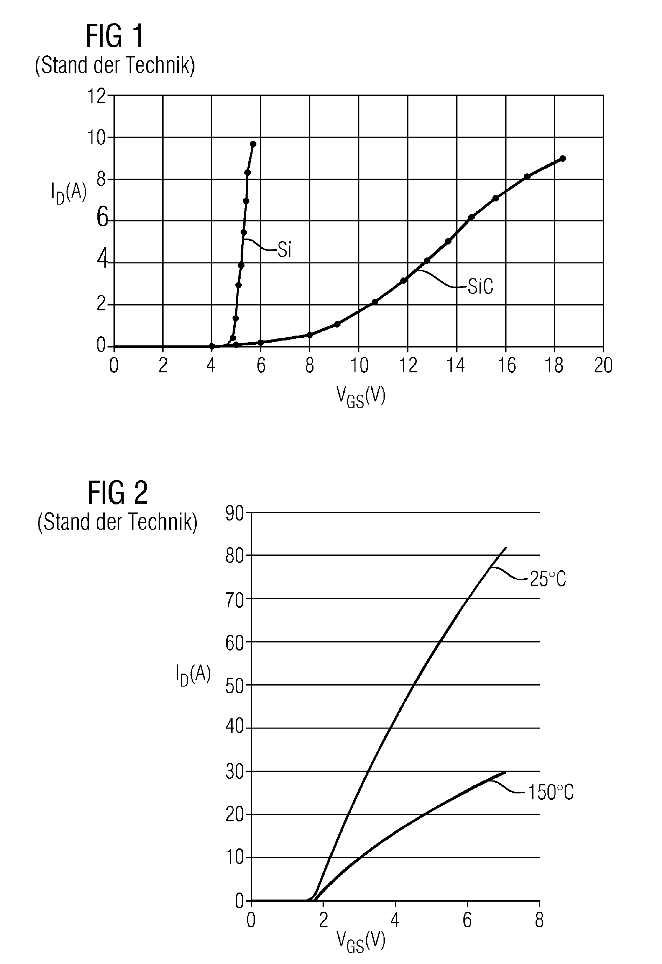

Bei Halbleiterschaltern liegt bei gegebener Steuerspannung ein gesättigter Betrieb vor, solange der von dem Halbleiterschalter geschaltete Strom unterhalb eines Maximalwerts liegt. Der Maximalwert ist eine Funktion der Steuerspannung. Konventionelle Halbleiterschalter weisen hierbei eine steile Übertragungskennlinie auf. Liegt die Steuerspannung nur geringfügig unter einem Minimalwert, so sperrt der Halbleiterschalter. Liegt die Steuerspannung nur geringfügig über dem Minimalwert, so weist der Halbleiterschalter bereits eine nennenswerte Stromtragfähigkeit auf. FIG 1 zeigt dies beispielhaft für einen typischen MOSFET-Leistungs-Halbleiterschalter mit einem maximalen Strom von 6 A und einer maximalen geschalteten Spannung von 1500 V. Die entsprechende Kennlinie ist in FIG 1 mit Si bezeichnet. Liegt die Steuerspannung unter ca. 4,8 V, ist die Stromtragfähigkeit nahezu 0. Liegt die Steuerspannung bei 6 V, liegt die Stromtragfähigkeit bereits über 10 A.

Konventionelle Halbleiterschalter weisen weiterhin eine erhebliche zulässige Steuerspannung auf. Beispielsweise bei dem in FIG 1 beschriebenen Halbleiterschalter darf die Steuerspannung bis zu 30 V betragen. Empfohlen wird für den konventionellen Halbleiterschalter gemäß FIG 1 eine Steuerspannung von 10 V.

Die Steuerspannung ist die Spannung des Steuersignals, wenn und solange der Halbleiterschalter von der Steuerschaltung durchgeschaltet wird. In diesem Fall weist das Steuersignal die oben genannte Steuerspannung (von beispielsweise 10 V) auf. Wenn und solange der Halbleiterschalter von der Steuerschaltung gesperrt wird, weist das Steuersignal den Spannungswert 0 auf.

Die Steuerspannung ist von der Versorgungsspannung abhängig. Schwankt die Versorgungsspannung, schwankt auch die Steuerspannung. Bei konventionellen spannungsgesteuerten Halbleiterschaltern stellt dies kein nennenswertes Problem dar. Denn die Versorgungsspannung kann ohne weiteres derart gewählt werden, dass sie zwar in nennenswertem Umfang oberhalb der empfohlenen Steuerspannung liegt, aber hinreichend unterhalb der maximal zulässigen Steuerspannung. In dem erläuterten Beispiel kann die Versorgungsspannung beispielsweise normalerweise bei 15 V oder bei 20 V liegen. Treten Schwankungen der Versorgungsspannung auf, ist dies unkritisch, solange 8 V nicht unterschritten und 30 V nicht überschritten werden.

Im Stand der Technik ist bekannt, die der Grundschaltung zugeführte Versorgungsspannung weiterhin einer Schutzschaltung zuzuführen. Alternativ oder zusätzlich kann der Schutzschaltung die Drain- bzw. Kollektorspannung des spannungsgesteuerten Halbleiterschalters zugeführt werden. Die Schutzschaltung ermittelt anhand der Versorgungsspannung bzw. der Drain- bzw. Kollektorspannung ein Schutzsignal für den Halbleiterschalter. Insbesondere wird das Ausgeben der - dann zu geringen - Steuerspannung an den Halbleiterschalter gesperrt, wenn die Versorgungsspannung unter einen kritischen Wert von beispielsweise 8 V sinkt oder anhand der Drain- bzw. Kollektorspannung des spannungsgesteuerten Halbleiterschalters eine Entsättigung des Halbleiterschalters erkannt wird.

In jüngerer Zeit sind neuartige spannungsgesteuerte Leistungs-Halbleiterschalter - insbesondere MOSFETs - bekannt geworden, die beispielsweise auf Siliziumcarbid (SiC) oder auf Galliumnitrid (GaN) basieren. Derartige Halbleiterschalter weisen erhebliche technische Vorteile auf. Allerdings weisen derartige MOSFETs gegenüber den konventionellen spannungsgesteuerten Halbleiterschaltern eine erheblich flachere Übertragungskennlinie auf. Dies wird nachfolgend anhand von FIG 1 für einen spannungsgesteuerten SiC-Halbleiterschalter mit einem maximalen Betriebsstrom von 5,5 A und einer geschalteten Spannung von maximal 1700 V erläutert. Die entsprechende Kennlinie ist in FIG 1 mit SiC bezeichnet. Gemäß FIG 1 beginnt die Leitfähigkeit bei ca. 4 V und steigt allmählich an, bis der Halbleiterschalter bei einer Steuerspannung von ca. 20 V seine maximale Stromleitfähigkeit von ca. 10 A erreicht.

Zusätzlich kann eine erhebliche Temperaturabhängigkeit der maximalen Stromtragfähigkeit bestehen. Rein beispielhaft ist in FIG 2 für einen GaN-MOSFET die maximale Stromtragfähigkeit in Abhängigkeit von der Temperatur des Halbleiterschalters angegeben. Ersichtlich variiert die Stromtragfähigkeit zwischen 25°C und 150°C um nahezu den Faktor 3.

Die neuartigen spannungsgesteuerten Leistungs-Halbleiterschalter weisen ebenfalls eine zulässige Steuerspannung auf. Beispielsweise bei dem in FIG 1 beschriebenen neuartigen Halbleiterschalter darf die Steuerspannung bis zu 22 V betragen. Empfohlen wird für diesen Halbleiterschalter eine Steuerspannung von 18 V. Bei dem in Verbindung mit FIG 2 beschriebenen Halbleiterschalter darf die Steuerspannung bis zu 10 V betragen. Empfohlen wird für diesen Halbleiterschalter eine Steuerspannung von 7 V.

Auch bei der Steuerschaltung für einen derartigen Halbleiterschalter kann die Versorgungsspannung schwanken. Aufgrund der empfohlenen Steuerspannung von 18 V und der maximal zulässigen Steuerspannung von 22 V für den SiC-MOSFET bzw. der empfohlenen Steuerspannung von 7 V und der maximal zulässigen Steuerspannung von 10 V für den GaN-MOSFET ist jedoch ohne weiteres ersichtlich, dass - und zwar sowohl absolut als auch relativ - Schwankungen der Versorgungsspannung nur in erheblich geringerem Umfang zulässig sind. Andere neuartige Halbleiterschalter weisen andere Werte für die empfohlene und die maximal zulässige Steuerspannung auf. Die Problematik ist jedoch stets dieselbe, nämlich dass Schwankungen der Versorgungsspannung nur in erheblich geringerem Umfang zulässig sind.

Es ist selbstverständlich möglich, die aus dem Stand der Technik bekannte Vorgehensweise auch bei der Steuerschaltung für den neuartigen Halbleiterschalter anzuwenden. Hierbei müsste jedoch eine erheblich engere Schwankungsbreite gewährleistet werden. Wenn dennoch größere Schwankungen auftreten, würde dies zu einem Abschalten der Steuerschaltung führen und demzufolge zu einer unerwünschten Unterbrechung des Betriebs einer vom Halbleiterschalter versorgten Einrichtung. Anderenfalls müsste die Gefahr in Kauf genommen werden, dass der Halbleiterschalter während der Zeitdauer eines Absinkens der Versorgungsspannung weder im sicheren gesättigten noch im sicheren gesperrten Betrieb betrieben wird und dadurch sehr schnell thermisch zerstört wird.

Für konventionelle Halbleiterschalter existieren Standard-Steuerschaltungen wie beispielsweise die eingangs erwähnten Schaltkreise der Firma Texas Instruments. Für die neuartigen Halbleiterschalter existieren keine derartigen Standard-Steuerschaltungen.

Die Aufgabe der vorliegenden Erfindung besteht darin, Möglichkeiten zu schaffen, die neuartigen Halbleiterschalter sicher und zuverlässig zu betreiben.

Die Aufgabe wird durch eine Steuerschaltung mit den Merkmalen des Anspruchs 1 gelöst. Vorteilhafte Ausgestaltungen der erfindungsgemäßen Steuerschaltung sind Gegenstand der abhängigen Ansprüche 2 bis 13.

Erfindungsgemäß wird bei einer Steuerschaltung der eingangs genannten Art das Schutzsignal auf die Abweichung des Stromistwerts vom Stromsollwert aufgeschaltet. Die Schutzschaltung ist derart ausgebildet,
- dass das Schutzsignal einen Basiswert aufweist, wenn die Versorgungsspannung einen Nennwert aufweist,
- dass das Schutzsignal einen Zwischenwert zwischen dem Basiswert und einem Grenzwert annimmt, wenn die Versorgungsspannung einen Wert unterhalb des Nennwerts aufweist,
- dass das Schutzsignal mindestens den Basiswert aufweist, wenn die Versorgungsspannung einen Wert oberhalb des Nennwerts aufweist und der Grenzwert kleiner als der Basiswert ist, und höchstens den Basiswert aufweist, wenn die Versorgungsspannung einen Wert oberhalb des Nennwerts aufweist und der Grenzwert größer als der Basiswert ist, und
- dass der Wert des Schutzsignals eine stetige, monotone Funktion des Wertes der Versorgungsspannung ist, so dass das Schutzsignal je nach Wert der Versorgungsspannung jeden Wert zwischen dem Basiswert und dem Grenzwert annehmen kann.

Dadurch wird erreicht, dass der vom spannungsgesteuerten Halbleiterschalter geschaltete Strom auf einen zulässigen Wert begrenzt wird, wobei der zulässige Wert nach Art einer stetigen und in der Regel monotonen Funktion in Abhängigkeit von der Versorgungsspannung bestimmt wird.

Vorzugsweise ist die Grundschaltung als integrierter Schaltkreis ausgebildet, beispielsweise als integrierter Schaltkreis vom Typ UCC28C40 (oder anderer Schaltkreis der entsprechenden Serie von Texas Instruments). Die Schutzschaltung kann in diesem Fall ebenfalls als (eigenständiger) integrierter Schaltkreis ausgebildet sein. Alternativ kann die Schutzschaltung in diesem Fall als aus diskreten elektronischen Bauelementen aufgebaute Schaltung ausgebildet sein. Besonders bevorzugt ist, dass die Steuerschaltung als integrierter Schaltkreis ausgebildet ist, der sowohl die Grundschaltung als auch die Schutzschaltung enthält.

Es ist möglich, dass das Schutzsignal dadurch auf die Abweichung des Stromistwerts vom Stromsollwert aufgeschaltet wird, dass das Schutzsignal auf den Stromsollwert aufgeschaltet wird. Ein Vorteil dieser Ausgestaltung besteht darin, dass es ohne weiteres möglich ist, die Schutzschaltung derart auszubilden, dass das Schutzsignal den Basiswert aufweist, wenn die Versorgungsspannung einen Wert oberhalb des Nennwerts aufweist. Alternativ ist es möglich, dass das Schutzsignal dadurch auf die Abweichung des Stromistwerts vom Stromsollwert aufgeschaltet wird, dass das Schutzsignal auf den Stromistwert aufgeschaltet wird.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung der Ausführungsbeispiele, die in Verbindung mit den Zeichnungen näher erläutert werden. Hierbei zeigen in schematischer Darstellung:
- FIG 1: Übertragungskennlinien von spannungsgesteuerten Halbleiterschaltern,
- FIG 2: eine weitere Übertragungskennlinie eines spannungsgesteuerten Halbleiterschalters,
- FIG 3: einen spannungsgesteuerten Halbleiterschalter einschließlich zugehöriger Steuerschaltung,
- FIG 4: einen funktionalen Verlauf eines Schutzsignals,
- FIG 5: eine Strombegrenzungs-Kennlinie und
- FIG 6 bis 8: mögliche schaltungstechnische Realisierungen von Steuerschaltungen.

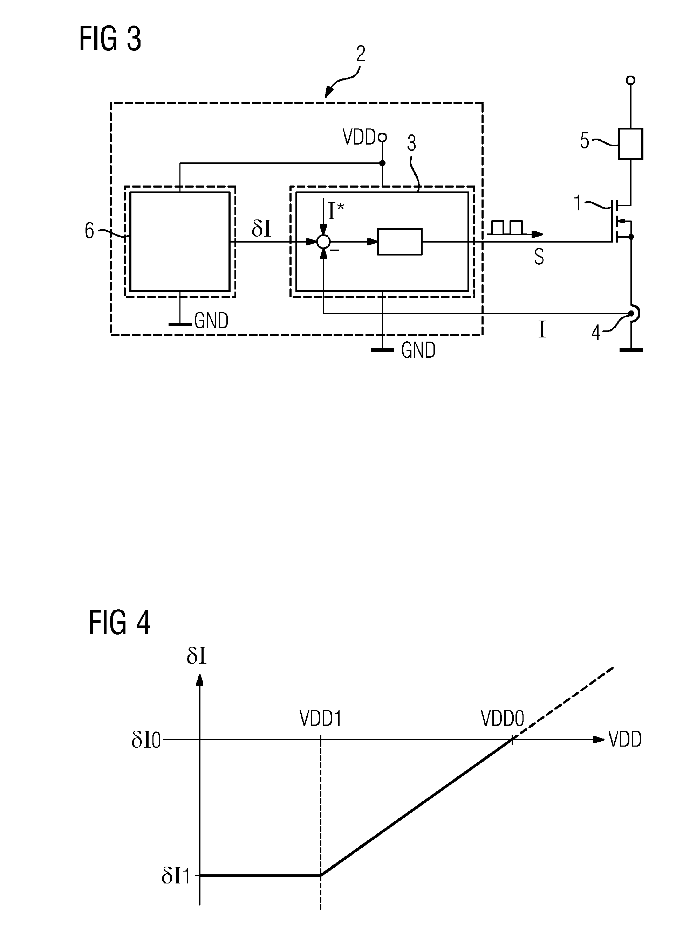

Gemäß FIG 3 wird ein spannungsgesteuerter Halbleiterschalter 1 von einer Steuerschaltung 2 gesteuert. Der spannungsgesteuerte Halbleiterschalter 1 kann beispielsweise als IGBT oder als MOSFET realisiert sein. Er kann insbesondere auf SiC-Basis oder GaN-Basis realisiert sein.

Die Steuerschaltung 2 weist eine Grundschaltung 3 auf. Der Grundschaltung 3 wird ein Stromistwert I des spannungsgesteuerten Halbleiterschalters 1 zugeführt. Der Stromistwert I kann beispielsweise mittels eines üblichen Stromsensors 4 erfasst werden. Die Grundschaltung 3 führt ein binäres Steuersignal S in Abhängigkeit von der Abweichung des Stromistwerts I von einem Stromsollwert I* nach. Insbesondere kann die Grundschaltung 3 eine Pulsweitenmodulation oder eine Pulsfrequenzmodulation des Steuersignals S durchführen. Das entsprechend nachgeführte Steuersignal S gibt die Grundschaltung 3 an den spannungsgesteuerten Halbleiterschalter 1 aus. Sie steuert dadurch den spannungsgesteuerten Halbleiterschalter 1 entsprechend. Der Grundschaltung 3 wird weiterhin eine Versorgungsspannung VDD zugeführt. Die Versorgungsspannung VDD ist auf ein Basispotential GND der Grundschaltung 3 (in der Regel das Erdpotential) bezogen. Mittels der Versorgungsspannung VDD wird die Grundschaltung 3 mit elektrischer Energie versorgt.

Die Funktionalität der Grundschaltung 3 ist Fachleuten allgemein bekannt. Insbesondere arbeiten die integrierten Schaltkreise mit den Typenbezeichnungen UCCx8C4y (mit x = 1 oder 2 und y = 1 bis 5) der Firma Texas Instruments Inc. nach diesem Prinzip. Weiterhin arbeiten auch die älteren integrierten Schaltkreise der Firma Texas Instruments Inc. mit den Typenbezeichnungen UCx84yA (mit x = 1, 2 oder 3 und y = 2 bis 5) nach diesem Prinzip.

In der Regel liegt der Stromistwert I weit unterhalb des Stromsollwerts I*. Dies führt in der Praxis dazu, dass der Halbleiterschalter 1 so weit wie möglich ausgesteuert wird. Der Stromistwert I steigt dennoch nicht auf unzulässig hohe Werte an, weil beispielsweise eine über den Halbleiterschalter 1 mit elektrischer Energie versorgte Last 5 dies verhindert. Wenn jedoch - beispielsweise aufgrund eines Kurzschlusses - der Stromistwert I bei maximaler Aussteuerung des Halbleiterschalters 1 auf unzulässig hohe Werte ansteigen würde, verhindert die Grundschaltung 3 einen derartigen Anstieg. Denn in diesem Fall würde die Aussteuerung des Halbleiterschalters 1 entsprechend reduziert. Im Ergebnis bewirkt die obenstehend erläuterte Funktionalität der Grundschaltung 3 daher nicht eine Stromregelung im engeren Sinne, sondern eine Spannungsregelung mit Spitzenstrombegrenzung.

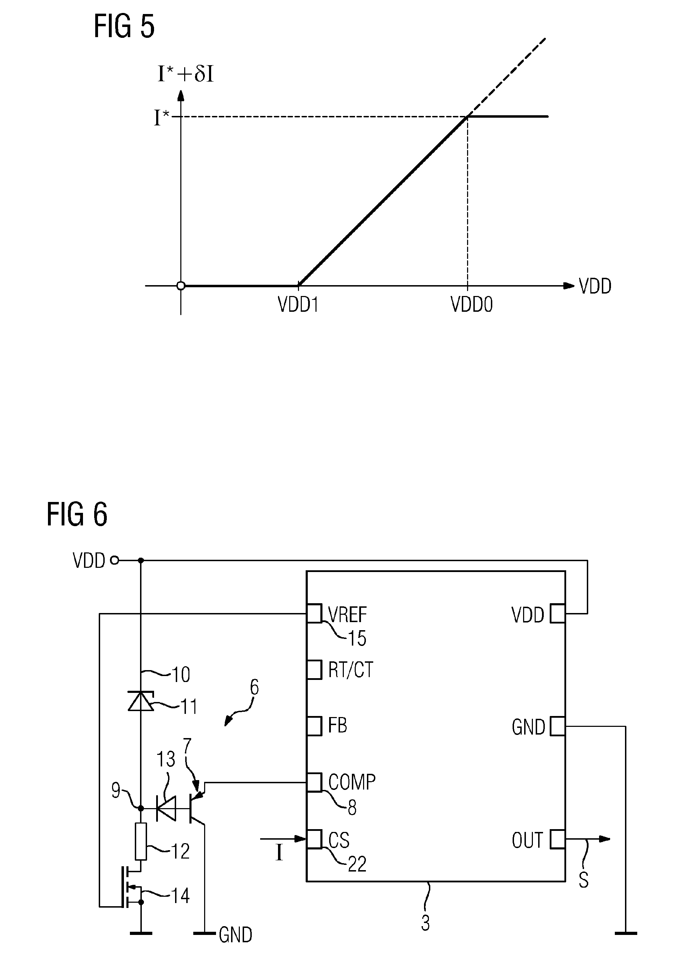

Die der Grundschaltung 3 zugeführte Versorgungsspannung VDD wird weiterhin einer Schutzschaltung 6 zugeführt. Die Schutzschaltung 6 ermittelt anhand der Versorgungsspannung VDD ein Schutzsignal δI. Das Schutzsignal δI wird auf die Abweichung des Stromistwerts I vom Stromsollwert I* aufgeschaltet. Das Schutzsignal δI bewirkt, dass der Stromistwert I in dem Fall, dass die Versorgungsspannung VDD unter ihren Nennwert VDD0 (siehe FIG 4) absinkt, auf zulässige Werte begrenzt wird. Dies wird nachstehend in Verbindung mit den FIG 4 und 5 näher erläutert.

Die Schutzschaltung 6 ist derart ausgebildet, dass das Schutzsignal δI gemäß FIG 4 einen Basiswert δI0 aufweist, wenn die Versorgungsspannung VDD einen Nennwert VDD0 aufweist. Wenn beispielsweise der Nennwert VDD0 der Versorgungsspannung VDD einen Wert von 15 V aufweist, kann der Basiswert δI0 beispielsweise einen Wert von 0 aufweisen. Wenn die Versorgungsspannung VDD auf einen Minimalwert VDD1 absinkt, nimmt das Schutzsignal δI einen Grenzwert δI1 an. Der Grenzwert δI1 kann beispielsweise (betragsmäßig) gleich dem Stromsollwert I* sein. Wenn entsprechend der Darstellung in FIG 3 das Schutzsignal δI additiv auf die Abweichung von Stromsollwert I* und Stromistwert I aufgeschaltet wird und der Grenzwert δI1 den Wert -I* aufweist, hat dies zur Folge, dass der Strom durch den spannungsgesteuerten Halbleiterschalter 1 auf einen resultierenden Stromsollwert von 0 begrenzt wird. Wenn die Versorgungsspannung VDD einen Wert zwischen dem Nennwert VDD0 und dem Minimalwert VDD1 aufweist, nimmt das Schutzsignal δI einen Zwischenwert an, der zwischen dem Basiswert δI0 und dem Grenzwert δI1 liegt.

Wenn hingegen die Versorgungsspannung VDD einen Wert oberhalb des Nennwerts VDD0 aufweist, ist es entsprechend der Darstellung in FIG 4 möglich (und in der Regel auch bevorzugt), dass das Schutzsignal δI exakt den Basiswert δI0 aufweist. Alternativ ist es möglich, wie in FIG 4 gestrichelt angedeutet, dass das Schutzsignal δI auf Werte oberhalb des Basiswerts δI0 ansteigt. Diese Aussage gilt, wenn - wie in FIG 4 dargestellt - der Grenzwert δI1 kleiner als der Basiswert δI0 ist. Wenn umgekehrt der Grenzwert δI1 größer als der Basiswert δI0 ist, besteht die alternative Realisierung darin, dass das Schutzsignal δI im Falle eines Ansteigens der Versorgungsspannung VDD auf Werte oberhalb des Nennwerts VDD0 auf Werte unterhalb des Basiswerts δI0 absinkt.

Das Schutzsignal δI ist ein analoges Signal. Weiterhin ist das Schutzsignal δI entsprechend der Darstellung in FIG 4 eine stetige, monotone Funktion des Wertes der Versorgungsspannung VDD. Oftmals ist der Verlauf (zumindest zwischen dem Nennwert VDD0 und dem Minimalwert VDD1 der Versorgungsspannung VDD) sogar streng monoton. Je nach Wert der Versorgungsspannung VDD kann das Schutzsignal δI somit jeden Wert zwischen dem Basiswert δI0 und dem Grenzwert δI1 annehmen. Der in FIG 4 gezeigte Verlauf des Schutzsignals δI, bei dem das Schutzsignal 51 - zumindest zwischen dem Nennwert VDD0 und dem Minimalwert VDD1 der Versorgungsspannung VDD - eine lineare Funktion des Wertes der Versorgungsspannung VDD ist, stellt eine einfache Realisierung des gewünschten Verlaufs dar. Es sind jedoch auch andere Verläufe möglich und denkbar.

FIG 5 zeigt die Wirkung, die sich durch die erfindungsgemäße Ermittlung des Schutzsignals δI ergibt. Gemäß FIG 5 wird der wirksame Stromsollwert (also der sich nach Berücksichtigung von eigentlichem Stromsollwert I* und Schutzsignal δI ergebende Wert) bei sinkender Versorgungsspannung VDD reduziert. Dargestellt ist in FIG 5 eine lineare Reduzierung. Dies ist zwar in der Regel einfach zu realisieren, hinreichend und vorteilhaft. Sie ist jedoch nicht zwingend. Entscheidend ist, dass die Reduzierung derart ist, dass für jeden Wert der Versorgungsspannung VDD der wirksame Stromsollwert derart festgelegt ist, dass der spannungsgesteuerte Halbleiterschalter 1 stets im gesättigten Bereich betrieben wird. Insbesondere folgt der wirksame Stromsollwert (= maximal zulässiger Strom) idealerweise mit einem Sicherheitsabstand der Übertragungscharakteristik des jeweiligen Halbleiterschalters 1.

Die Grundschaltung 3 kann als integrierter Schaltkreis ausgebildet sein. Dies ist in FIG 3 durch eine gestrichelte Umrahmung der Grundschaltung 3 angedeutet. Die Schutzschaltung 6 kann als diskrete Schaltung ausgebildet sein, also aus diskreten elektronischen Bauelementen aufgebaut sein. Mögliche Ausgestaltungen mit diskreten elektronischen Bauelementen werden später in Verbindung mit den FIG 6 bis 8 erläutert werden. Es ist jedoch ebenso möglich, die Schutzschaltung 6 innerhalb eines integrierten Schaltkreises zu realisieren. Hierbei ist es möglich, dass die Schutzschaltung 6 als eigenständiger integrierter Schaltkreis ausgebildet ist. Dies ist in FIG 3 durch eine gestrichelte Umrahmung der Schutzschaltung 6 angedeutet. Alternativ ist es möglich, die Grundschaltung 3 und die Schutzschaltung 6 in einem einheitlichen, gemeinsamen integrierten Schaltkreis zu realisieren. Dies ist in FIG 3 durch eine gemeinsame gestrichelte Umrahmung der Grundschaltung 3 und der Schutzschaltung 6, also der Steuerschaltung 2 insgesamt, angedeutet.

Nachstehend werden mehrere konkrete mögliche Ausgestaltungen insbesondere der Schutzschaltung 6 näher erläutert. Diese Ausgestaltungen werden in Verbindung mit einer Realisierung der Grundschaltung 3 als integrierter Schaltkreis gemäß der Baureihe UCCx8C4y der Firma Texas Instruments Inc. erläutert. Auf die Funktion und Wirkungsweise der Grundschaltung 3 wird daher nachstehend nur eingegangen, soweit dies für das Verständnis der Erfindung erforderlich ist. Die Grundschaltung 3 könnte jedoch auch anders ausgebildet sein, sei es als anderer integrierter Schaltkreis, sei es als aus diskreten elektronischen Bauelementen bestehende Schaltung. In diesen Fällen sind gegebenenfalls Anpassungen der Schutzschaltung 6 erforderlich.

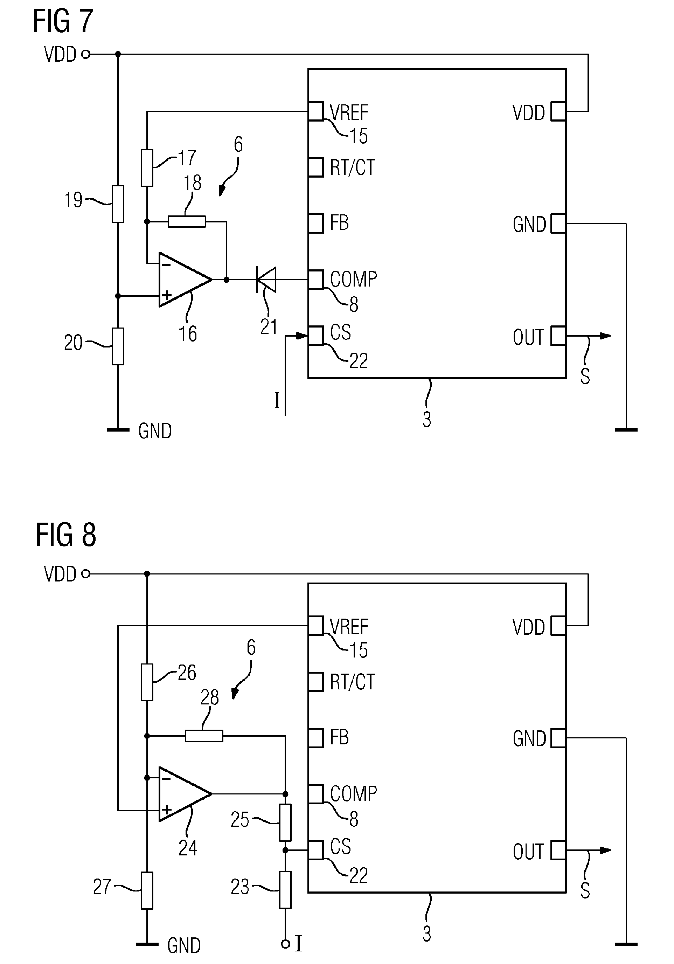

Das Schutzsignal δI kann direkt auf die Abweichung des Stromistwerts I vom Stromsollwert I* aufgeschaltet werden. Da die Abweichung des Stromistwerts I vom Stromsollwert I* sich durch die Differenz von Stromistwert I und Stromsollwert I* ergibt, kann das Schutzsignal δI mit gleicher Wirkung jedoch alternativ ebenso auf den Stromistwert I oder den Stromsollwert I* aufgeschaltet werden. Nachstehend werden zunächst in Verbindung mit den FIG 6 und 7 zwei mögliche Ausgestaltungen erläutert werden, bei denen das Schutzsignal δI auf den Stromsollwert I* aufgeschaltet wird. Sodann wird in Verbindung mit FIG 8 eine mögliche Ausgestaltung erläutert werden, bei der das Schutzsignal δI auf den Stromistwert I aufgeschaltet wird.

Bei der Ausgestaltung gemäß FIG 6 weist die Schutzschaltung 6 einen Transistor 7 auf. Der Emitter des Transistors 7 ist mit einem Anschluss 8 der Grundschaltung 3 verbunden, an dem der Stromsollwert I* ansteht. Bei den integrierten Schaltkreisen gemäß der Baureihe UCCx8C4y der Firma Texas Instruments Inc. ist dieser Anschluss als COMP bezeichnet und trägt dort die PIN-Nummer 1. Der COMP-Anschluss 8 ist in der Regel über ein RC-Netzwerk mit dem FB-Anschluss des genannten integrierten Schaltkreises verbunden. Der Kollektor des Transistors 7 ist mit dem Basispotential GND verbunden. Die Basis des Transistors 7 ist über einen Knotenpunkt 9 einer Leitung 10 verbunden. Die Leitung 10 ist, ausgehend vom Knotenpunkt 9, über eine Zenerdiode 11 mit der Versorgungsspannung VDD verbunden. Weiterhin ist die Leitung 10, ausgehend vom Knotenpunkt 9, über einen Widerstand 12 mit dem Basispotential GND verbunden. Vorzugsweise ist weiterhin zwischen der Basis des Transistors 7 und dem Knotenpunkt 9 eine Diode 13 angeordnet. Die Diode 13 dient dem Schutz des Transistors 7 vor Überspannung. Falls der Transistor 7 eine hinreichende Spannungsfestigkeit aufweist, kann die Diode 13 jedoch entfallen.

Zwischen dem Knotenpunkt 9 und dem Basispotential GND ist weiterhin ein elektronischer Schalter 14 angeordnet. Der elektronische Schalter 14 wird vorzugsweise mittels eines Referenzpotentials VREF geschaltet, das aus der Versorgungsspannung VDD abgeleitet wird. Das Referenzpotential VREF kann beispielsweise 5 V betragen. Es wird gemäß FIG 6 von der Grundschaltung 3 an einem weiteren Anschluss 15 zur Verfügung gestellt, kann also an dem Anschluss 15 der Grundschaltung 3 abgegriffen werden. Bei den integrierten Schaltkreisen gemäß der Baureihe UCCx8C4y der Firma Texas Instruments Inc. ist der Anschluss 15 als VREF bezeichnet und trägt dort die PIN-Nummer 8. Der elektronische Schalter 14 bewirkt, dass die Schutzschaltung 6 erst dann aktiviert wird, wenn die Grundschaltung 3 über den Anschluss 15 das Referenzpotential VREF zur Verfügung stellt. Der elektronische Schalter 14 ist nicht zwingend erforderlich.

Die Dimensionierung der Schutzschaltung 6 von FIG 6 kann nach Bedarf erfolgen. In Versuchen hat sich in dem Fall, dass der spannungsgesteuerte Halbleiterschalter 1 ein SiC-MOSFET ist, insbesondere ein MOSFET vom Typ C2M1000170D, folgende Dimensionierung als vorteilhaft erwiesen:
VDD: 16 V
Sperrspannung der Zenerdiode: 10 V
Widerstandswert des Widerstands: 4,7 kΩ

Bei der Ausgestaltung gemäß FIG 7 weist die Schutzschaltung 6 einen Operationsverstärker 16 auf. Der Ausgang des Operationsverstärkers 16 ist mit dem Anschluss 8 der Grundschaltung 3 verbunden, an dem der Stromsollwert I* ansteht, vergleiche die obenstehenden Ausführungen zu FIG 6. Die Verschaltung des COMP-Anschlusses 8 mit dem FB-Anschluss des genannten integrierten Schaltkreises ist analog zu der Ausgestaltung von FIG 6. Ein invertierender Eingang des Operationsverstärkers 16 ist über einen ersten Widerstand 17 mit dem Referenzpotential VREF und über einen zweiten Widerstand 18 mit dem Ausgang des Operationsverstärkers 16 verbunden. Ein nicht invertierender Eingang des Operationsverstärkers 16 ist über einen dritten Widerstand 19 mit der Versorgungsspannung VDD und über einen vierten Widerstand 20 mit dem Basispotential GND verbunden. Zusätzlich kann zwischen dem Ausgang des Operationsverstärkers 16 und dem Anschluss 8 der Grundschaltung 3 eine Diode 21 angeordnet sein.

Die Dimensionierung der Schutzschaltung 6 von FIG 7 kann nach Bedarf erfolgen. In Versuchen hat sich in dem Fall, dass der spannungsgesteuerte Halbleiterschalter 1 ein SiC-MOSFET ist, insbesondere ein MOSFET vom Typ C2M1000170D, folgende Dimensionierung als vorteilhaft erwiesen:
Widerstandswert des ersten Widerstands: 4,7 kΩ
Widerstandswert des zweiten Widerstands: 4,7 kΩ
Widerstandswert des dritten Widerstands: 10 kΩ
Widerstandswert des vierten Widerstands: 4,7 kΩ

Der Grundschaltung 3 muss - selbstverständlich - auch der Stromistwert I zugeführt werden. Dies erfolgt über einen weiteren Anschluss 22 der Grundschaltung 3. Bei den integrierten Schaltkreisen gemäß der Baureihe UCCx8C4y der Firma Texas Instruments Inc. ist der Anschluss 22 als CS bezeichnet und trägt dort die PIN-Nummer 3. Bei den Ausgestaltungen der FIG 6 und 7 wird der Stromistwert I direkt dem Anschluss 22 zugeführt. Bei der Ausgestaltung der Schutzschaltung 6 gemäß FIG 8 wird der Stromistwert I dem Anschluss 22 hingegen über einen ersten Widerstand 23 zugeführt. Die Schutzschaltung 6 gemäß der Ausgestaltung von FIG 8 weist ebenfalls einen Operationsverstärker 24 auf. Der Ausgang des Operationsverstärkers 24 ist über einen zweiten Widerstand 25 mit dem Anschluss 22 der Grundschaltung 3 verbunden, über den auch der Stromistwert I der Grundschaltung 3 zugeführt wird. Ein invertierender Eingang des Operationsverstärkers 24 ist über einen dritten Widerstand 26 mit der Versorgungsspannung VDD, über einen vierten Widerstand 27 mit dem Basispotential GND und über einen fünften Widerstand 28 mit dem Ausgang des Operationsverstärkers 24 verbunden. Ein nicht invertierender Eingang des Operationsverstärkers 24 ist mit dem Referenzpotential VREF verbunden.

Die Dimensionierung der Schutzschaltung 6 von FIG 8 kann nach Bedarf erfolgen. In Versuchen hat sich in dem Fall, dass der spannungsgesteuerte Halbleiterschalter 1 ein SiC-MOSFET ist, insbesondere ein MOSFET vom Typ C2M1000170D, folgende Dimensionierung als vorteilhaft erwiesen:
Widerstandswert des ersten Widerstands: 4,7 kΩ
Widerstandswert des zweiten Widerstands: 18 kΩ
Widerstandswert des dritten Widerstands: 4,7 kΩ
Widerstandswert des vierten Widerstands: 5,6 kΩ
Widerstandswert des fünften Widerstands: 4,7 kΩ

Gemäß obenstehenden Ausführungen wird sowohl bei der Ausgestaltung von FIG 6 als auch bei der Ausgestaltung von FIG 7 als auch bei der Ausgestaltung von FIG 8 das Referenzpotential VREF an dem weiteren Anschluss 15 der Grundschaltung 3 abgegriffen. Dies ist bei üblichen, kommerziellen erhältlichen Grundschaltungen 3 ohne weiteres möglich, da diese standardmäßig das Referenzpotential VREF ausgeben. Alternativ ist es möglich, das Referenzpotential VREF separat vorzugeben oder separat aus der Versorgungsspannung VDD abzuleiten.

Die Schutzschaltungen 6 nach den FIG 6 und 7 bringen den Vorteil mit sich, dass das Schutzsignal δI den Basiswert δI0 aufweist, wenn die Versorgungsspannung VDD einen Wert oberhalb des Nennwerts VDD0 aufweist. Oberhalb des Nennwerts VDD0 der Versorgungsspannung VD erfolgt also keine Erhöhung des maximal zulässigen Stroms. Der maximal zulässige Strom bleibt vielmehr auf den Stromsollwert I* begrenzt.

Obenstehend wurde ausschließlich die erfindungsgemäße Überwachung der Versorgungsspannung VDD erläutert. Diese Überwachung kann gegebenenfalls um eine Anpassung des Schutzsignals δI in Abhängigkeit von der Temperatur des spannungsgesteuerten Halbleiterschalters 1 ergänzt werden. Weiterhin ist es möglich, zusätzlich zu der erfindungsgemäßen Überwachung der Versorgungsspannung VDD auch eine Spannungsüberwachung des Standes der Technik zu realisieren. Diese konventionelle Spannungsüberwachung kann beispielsweise bewirken, dass die Grundschaltung 3 abgeschaltet wird, wenn die Versorgungsspannung VDD unter einen kritischen Wert fällt. Alternativ oder zusätzlich kann diese konventionelle Spannungsüberwachung kann beispielsweise bewirken, dass die Grundschaltung 3 das Ausgeben des Steuersignals S an den spannungsgesteuerten Halbleiterschalter 1 unterdrückt, wenn die Versorgungsspannung VDD über einen kritischen Wert ansteigt.

Zusammengefasst betrifft die vorliegende Erfindung somit folgenden Sachverhalt:
Eine Steuerschaltung 2 für einen spannungsgesteuerten Halbleiterschalter 1 weist eine Grundschaltung 3 auf, der ein Stromistwert I des Halbleiterschalters 1 zugeführt wird. Die Grundschaltung 3 führt ein binäres Steuersignal S in Abhängigkeit von der Abweichung des Stromistwerts I von einem Stromsollwert I* nach. Das Steuersignal S gibt sie an den Halbleiterschalter 1 aus und steuert den Halbleiterschalter 1 dadurch entsprechend. Der Grundschaltung 3 wird eine Versorgungsspannung VDD zugeführt, die weiterhin auch einer Schutzschaltung 6 zugeführt wird. Die Schutzschaltung 6 ermittelt anhand der Versorgungsspannung VDD ein Schutzsignal δI, das zur Begrenzung des vom Halbleiterschalter 1 geschalteten Stroms I auf die Abweichung des Stromistwerts I vom Stromsollwert I* aufgeschaltet wird. Das Schutzsignal δI weist einen Basiswert δI0 auf, wenn die Versorgungsspannung VDD einen Nennwert VDD0 aufweist. Liegt die Versorgungsspannung VDD unterhalb des Nennwerts VDD0, nimmt das Schutzsignal δI einen Zwischenwert zwischen dem Basiswert δI0 und einem Grenzwert δI1 an. Liegt die Versorgungsspannung VDD oberhalb des Nennwerts VDD0, so weist das Schutzsignal δI mindestens den Basiswert δI0 auf, wenn der Grenzwert δI1 kleiner als der Basiswert δI0 ist. Wenn hingegen der Grenzwert δI1 größer als der Basiswert δI0 ist, so weist das Schutzsignal δI höchstens den Basiswert δI0 auf. Der Wert des Schutzsignals δI ist eine stetige, monotone Funktion des Wertes der Versorgungsspannung VDD, so dass das Schutzsignal δI je nach Wert der Versorgungsspannung VDD jeden Wert zwischen dem Basiswert δI0 und dem Grenzwert δI1 annehmen kann.

Die vorliegende Erfindung weist viele Vorteile auf. Insbesondere ist es möglich, bei spannungsgesteuerten Halbleiterschaltern 1 auf SiC- und GaN-Basis trotz Schwankungen der Versorgungsspannung VDD der Steuerschaltung 2 einen zuverlässigen Betrieb zu gewährleisten. Dies gilt auch unter nicht regulären Betriebsbedingungen. Hierbei können sowohl ein vorzeitiges Abschalten des spannungsgesteuerten Halbleiterschalters 1 als auch eine Beschädigung des spannungsgesteuerten Halbleiterschalters 1 zuverlässig vermieden werden. Dennoch können bewährte, in Form von integrierten Schaltkreisen kommerziell zur Verfügung stehende Grundschaltungen 3 verwendet werden.

Besonders vorteilhaft findet die erfindungsgemäße Steuerschaltung 2 (einschließlich des spannungsgesteuerten Halbleiterschalters 1) bei einem Schaltnetzteil Anwendung. Es sind jedoch auch andere Anwendungen möglich.

Obwohl die Erfindung im Detail durch das bevorzugte Ausführungsbeispiel näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

## Patentansprüche

1. Steuerschaltung für einen spannungsgesteuerten Halbleiterschalter (1),
- wobei die Steuerschaltung eine Grundschaltung (3) aufweist,
- wobei der Grundschaltung (3) ein Stromistwert (I) des spannungsgesteuerten Halbleiterschalters (1) zugeführt wird,
- wobei die Grundschaltung (3) ein binäres Steuersignal (S) in Abhängigkeit von der Abweichung des Stromistwerts (I) von einem Stromsollwert (I*) nachführt,
- wobei die Grundschaltung (3) das entsprechend nachgeführte Steuersignal (S) an den spannungsgesteuerten Halbleiterschalter (1) ausgibt und den spannungsgesteuerten Halbleiterschalter (1) dadurch entsprechend steuert,
- wobei der Grundschaltung (3) eine Versorgungsspannung (VDD) zugeführt wird,
- wobei die der Grundschaltung (3) zugeführte Versorgungsspannung (VDD) weiterhin einer Schutzschaltung (6) zugeführt wird,
- wobei die Schutzschaltung (6) anhand der Versorgungsspannung (VDD) ein Schutzsignal (δI) ermittelt,
- wobei das Schutzsignal (δI) auf die Abweichung des Stromistwerts (I) vom Stromsollwert (I*) aufgeschaltet wird,
- wobei die Schutzschaltung (6) derart ausgebildet ist,
-- dass das Schutzsignal (δI) einen Basiswert (δI0) aufweist, wenn die Versorgungsspannung (VDD) einen Nennwert (VDD0) aufweist,
-- dass das Schutzsignal (δI) einen Zwischenwert zwischen dem Basiswert (δI0) und einem Grenzwert (δI1) annimmt, wenn die Versorgungsspannung (VDD) einen Wert unterhalb des Nennwerts (VDD0) aufweist,
-- dass das Schutzsignal (δI) mindestens den Basiswert (δI0) aufweist, wenn die Versorgungsspannung (VDD) einen Wert oberhalb des Nennwerts (VDD0) aufweist und der Grenzwert (δI1) kleiner als der Basiswert (δI0) ist, und höchstens den Basiswert (δI0) aufweist, wenn die Versorgungsspannung (VDD) einen Wert oberhalb des Nennwerts (VDD0) aufweist und der Grenzwert (δI1) größer als der Basiswert (δI0) ist, und
-- dass der Wert des Schutzsignals (δI) eine stetige, monotone Funktion des Wertes der Versorgungsspannung (VDD) ist, so dass das Schutzsignal (δI) je nach Wert der Versorgungsspannung (VDD) jeden Wert zwischen dem Basiswert (δI0) und dem Grenzwert (δI1) annehmen kann.

2. Steuerschaltung nach Anspruch 1,
**dadurch gekennzeichnet, dass** die Grundschaltung (3) als integrierter Schaltkreis ausgebildet ist und dass die Schutzschaltung (6) als integrierter Schaltkreis oder als aus diskreten elektronischen Bauelementen aufgebaute Schaltung ausgebildet ist.

3. Steuerschaltung nach Anspruch 1,
**dadurch gekennzeichnet, dass** die Steuerschaltung als integrierter Schaltkreis ausgebildet ist, der sowohl die Grundschaltung (3) als auch die Schutzschaltung (6) enthält.

4. Steuerschaltung nach Anspruch 1, 2 oder 3,
**dadurch gekennzeichnet, dass** das Schutzsignal (δI) dadurch auf die Abweichung des Stromistwerts (I) vom Stromsollwert (I*) aufgeschaltet wird, dass das Schutzsignal (δI) auf den Stromsollwert (I*) aufgeschaltet wird.

5. Steuerschaltung nach Anspruch 4,
**dadurch gekennzeichnet,**
- **dass** die Schutzschaltung (6) einen Transistor (7) aufweist,
- **dass** der Emitter des Transistors (7) mit einem Anschluss (8) der Grundschaltung (3) verbunden ist, an dem der Stromsollwert (I*) ansteht,
- **dass** der Kollektor des Transistors (7) mit einem Basispotential (GND) der Grundschaltung (3) verbunden ist,
- **dass** die Basis des Transistors (7) mit einem Knotenpunkt (9) einer Leitung (10) verbunden ist und
- **dass** die Leitung (10), ausgehend vom Knotenpunkt (9), über eine in Sperrrichtung geschaltete Zenerdiode (11) mit der Versorgungsspannung (VDD) und über einen Widerstand (12) mit dem Basispotential (GND) der Grundschaltung (3) verbunden ist.

6. Steuerschaltung nach Anspruch 5,
**dadurch gekennzeichnet, dass** zwischen der Basis des Transistors (7) und dem Knotenpunkt (9) eine Diode (13) angeordnet ist.

7. Steuerschaltung nach Anspruch 4,
**dadurch gekennzeichnet,**
- **dass** die Schutzschaltung (6) einen Operationsverstärker (16) aufweist,
- **dass** der Ausgang des Operationsverstärkers (16) mit einem Anschluss (8) der Grundschaltung (3) verbunden ist, an dem der Stromsollwert (I*) ansteht,
- **dass** ein invertierender Eingang des Operationsverstärkers (16) über einen ersten Widerstand (17) mit einem definierten Referenzpotential (VREF) und über einen zweiten Widerstand (18) mit dem Ausgang des Operationsverstärkers (16) verbunden ist und
- **dass** ein nicht invertierender Eingang des Operationsverstärkers (16) über einen dritten Widerstand (19) mit der Versorgungsspannung (VDD) und über einen vierten Widerstand (20) mit einem Basispotential (GND) der Grundschaltung (3) verbunden ist.

8. Steuerschaltung nach Anspruch 7,
**dadurch gekennzeichnet, dass** zwischen dem Ausgang des Operationsverstärkers (16) und dem Anschluss (8) der Grundschaltung (3) eine Diode (21) angeordnet ist.

9. Steuerschaltung nach Anspruch 7 oder 8,
**dadurch gekennzeichnet, dass** das Referenzpotential (VREF) an einem weiteren Anschluss (15) der Grundschaltung (3) abgegriffen wird.

10. Steuerschaltung nach einem der Ansprüche 4 bis 9, **dadurch gekennzeichnet, dass** die Schutzschaltung (6) derart ausgebildet ist, dass das Schutzsignal (δI) den Basiswert (δI0) aufweist, wenn die Versorgungsspannung (VDD) einen Wert oberhalb des Nennwerts (VDD0) aufweist.

11. Steuerschaltung nach Anspruch 1, 2 oder 3,
**dadurch gekennzeichnet, dass** das Schutzsignal (δI) dadurch auf die Abweichung des Stromistwerts (I) vom Stromsollwert (I*) aufgeschaltet wird, dass das Schutzsignal (δI) auf den Stromistwert (I) aufgeschaltet wird.

12. Steuerschaltung nach Anspruch 11,
**dadurch gekennzeichnet,**
- **dass** der Stromistwert (I) über einen ersten Widerstand (23) einem Anschluss (22) der Grundschaltung (3) zugeführt wird,
- **dass** die Schutzschaltung (6) einen Operationsverstärker (24) aufweist,
- **dass** der Ausgang des Operationsverstärkers (24) über einen zweiten Widerstand (25) mit dem Anschluss (22) der Grundschaltung (3) verbunden ist, über den der Stromistwert (I) der Grundschaltung (3) zugeführt wird,
- **dass** ein invertierender Eingang des Operationsverstärkers (24) über einen dritten Widerstand (26) mit der Versorgungsspannung (VDD), über einen vierten Widerstand (27) mit einem Basispotential (GND) der Grundschaltung (3) und über einen fünften Widerstand (28) mit dem Ausgang des Operationsverstärkers (24) verbunden ist und
- **dass** ein nicht invertierender Eingang des Operationsverstärkers (24) mit einem definierten Referenzpotential (VREF) verbunden ist.

13. Steuerschaltung nach Anspruch 12,
**dadurch gekennzeichnet, dass** das Referenzpotential (VREF) an einem weiteren Anschluss (15) der Grundschaltung (3) abgegriffen wird.
